**Europäisches Patentamt**

**European Patent Office**

**Office européen des brevets**

(19)

(11) Publication number : **0 424 278 B1**

(12) **EUROPEAN PATENT SPECIFICATION**

(45) Date of publication of patent specification :
28.12.94 Bulletin 94/52

(51) Int. Cl.⁵ : **H01L 21/50, H01L 23/10**

(21) Application number : **90402960.0**

(22) Date of filing : **19.10.90**

(54) **Process for sealing a semiconductor device.**

(30) Priority : **20.10.89 JP 271860/89**

(43) Date of publication of application :
**24.04.91 Bulletin 91/17**

(45) Publication of the grant of the patent :
**28.12.94 Bulletin 94/52**

(84) Designated Contracting States :
**DE FR GB**

(56) References cited :
**IBM TECHNICAL DISCLOSURE BULLETIN,
vol. 29, no 8, January 1987, page 3754, New
York, US; "Membrane solder seal/membrane
epoxy seal"
PATENT ABSTRACTS OF JAPAN, vol. 11, no.
312 (E-548)[2759], 12th October 1987; &
JP-A-62 105 450
PATENT ABSTRACTS OF JAPAN, vol. 11, no.
130 (E-502)[2577], 23rd April 1987; & JP-A-61
276 239**

(56) References cited :
**PATENT ABSTRACTS OF JAPAN, vol. 10, no.
283 (E-440)[2339], 26th September 1986; &
JP-A-61 101 054
PATENT ABSTRACTS OF JAPAN, vol. 6, no.
170 (E-128)[1048], 3rd September 1982; & JP-
A-57 87 156
IBM TECHNICAL DISCLOSURE BULLETIN,
vol. 27, no. 3, August 1984, page 1701, New
York, US; W.W. OLAH et al.: "Hermetic seal for
semiconductor package"**

(73) Proprietor : **FUJITSU LIMITED
1015, Kamikodanaka
Nakahara-ku
Kawasaki-shi Kanagawa 211 (JP)**

(72) Inventor : **Hiraiwa, Katsuro
1104, Shimokodanaka,
Nakahara-ku
Kawasaki-shi, Kanagawa 211 (JP)**

(74) Representative : **Joly, Jean-Jacques et al
Cabinet Beau de Loménie
158, rue de l'Université
F-75340 Paris Cédex 07 (FR)**

EP 0 424 278 B1

## Description

BACKGROUND OF THE INVENTION

1. Field of the Invention

This invention relates to a semiconductor device, and more particularly, to a process for hermetically sealing a semiconductor device comprising a package base, on which a semiconductor chip is mounted, and a package cap which is secured and sealed to the base by a resin adhesive.

2. Description of the Related Art

A process for hermetically sealing a package cap onto a package base, on which a semiconductor chip is mounted, by a resin adhesive is well known in the prior art, and such a known process comprises the following steps:

First, a package base is provided with a cavity on which a semiconductor chip is mounted by a resin adhesive in a die-bonding process. The semiconductor chip has a plurality of electrical terminals which are connected to inner leads, respectively, of the package base by bonding wires in a wire-bonding process.

The package base is provided at the outer periphery of the cavity with a flat portion which is coated with a thermosetting resin adhesive, and a package cap is then placed on the package base and positioned thereon. The cap is pressed against the package base by a suitable means, such as a pressure clip, to press the cap and the base together in such a way that they cannot move relative to each other.

Then, the package comprising the base and cap is introduced into a furnace and the package is heated at a constant temperature, for example, approximately 150°C, to thermoset the resin adhesive, and after a predetermined time, the cap becomes firmly adhered to the base and the package is removed from the furnace. The pressure clip is then removed from the package, and an hermetic sealed semiconductor device is obtained.

The above-mentioned known process for hermetically sealing a package cap onto a package base, however, has several disadvantages, as mentioned below.

The pressure clip is set on the package at a room temperature, such as 20°C and under atmospheric pressure, and thus the cap is sealed to the package base by an adhesive resin at an ambient pressure. Therefore, after the package is placed in the furnace in which a constant temperature, for example, approximately 150°C, is maintained, the pressure in the cavity of the package becomes higher than the ambient pressure due to an expansion of the air confined in the cavity. For example, assuming that the room temperature is 20°C and the temperature of the furnace is 150°C, the pressure in the cavity becomes 1.44 times the ambient pressure.

Patent Abstracts of Japan, vol. 11, no. 130 (E-502) [2577], April 23 rd, 1987 and JP-A-61 276 239, discloses a method wherein two partly cured resin adhesives are provided on the abutted portion of the cup of a semiconductor package, followed by a sealing heat treatment to seal the closed package.

A pressure difference between a high pressure in the package cavity and the ambient pressure in the furnace causes the resin adhesion to be urged toward the outside of the package, and accordingly, the resin adhesive contact area between the package base and the cap is reduced or pin holes are created in the resin adhesive which causes various problems. For example, the sealing force of the resin adhesive is reduced.

SUMMARY OF THE INVENTION

An object of the present invention is to provide a reliable process for hermetically sealing a cap to a package base, by which a desirable sealing force of a resin adhesive provided between the package base and the cap can be obtained.

According to the present invention, there is provided a process for hermetically sealing a semiconductor device comprising a package base, on which a semiconductor chip is mounted, and a package cap, said base and cap having corresponding frame-shaped abutting portions for sealing said cap to said base by a resin adhesive provided between said abutting portions, characterized in that said process comprises the following steps of: coating said frame-shaped abutting portion of at least one of said base and said cap with a thermosetting silicon resin; hardening said silicon resin by heating said one of said base and said cap until said silicon resin is completely hardened and becomes a silicon rubber; coating said silicon rubber with a thermosetting sealing resin having a good adhesion to said silicon rubber; abutting said cap against said base; and heating said base and said cap while a pressure is exerted thereon to press said base and said cap together.

In the present invention, the silicon resin is completely transformed into a silicon rubber, which functions as a packing seal, and therefore, even if a pressure difference is generated between a high pressure in the package cavity and the ambient pressure in the furnace, the sealing resin is prevented from moving toward the outside and away from the cavity of the package base. Accordingly, a required sealing resin contact area between the package base and the cap can be obtained and the generation of pin holes in the sealing resin can be prevented.

BRIEF DESCRIPTION OF THE DRAWINGS

Figures 1A through 1D are a series of cross-sectional views illustrating an embodiment of a sealing process for a semiconductor device according to the present invention;

Figure 2 is a cross-sectional view of a second embodiment of a sealing process of this invention; and

Figure 3 is a cross-sectional view of a third embodiment of a sealing process of this invention.

DESCRIPTION OF THE PREFERRED EMBODIMENTS

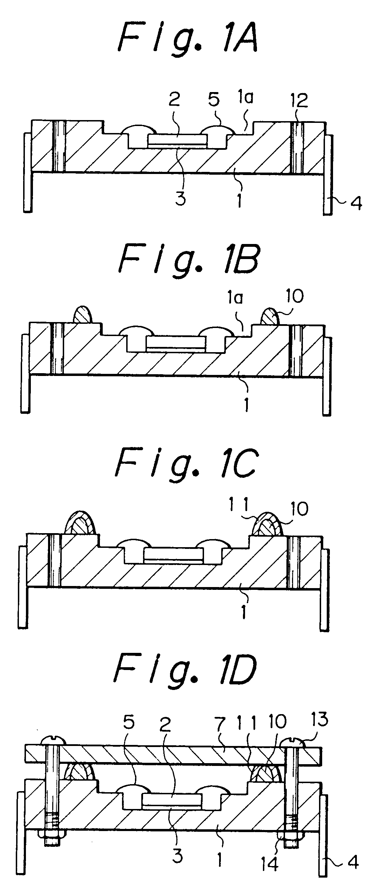

Referring now to the drawings, Figs. 1A through 1D illustrate a first embodiment of a sealing process for a semiconductor device according to the present invention.

As shown in Fig. 1A, a package base 1, made of a glass epoxy or ceramic, is provided with a cavity 1a in which a semiconductor chip 2 is mounted. The chip 2 is first mounted on the surface of the cavity 1a by a resin adhesive 3, in a die-bonding process. The semiconductor chip 2 has a plurality of electrical terminals which are connected to inner leads, respectively, of the package base 1 by bonding wires 5, in a wire-bonding process. The package base 1 is provided with through holes or screw holes 12 for attaching a package cover 7, as will be explained later. In Fig. 1A, reference numeral 4 denotes outer leads provided on the outer wall of the package base 1.

The package base 1 is provided at the outer periphery of the cavity 1a with a flat portion, i.e., a frame-shaped abutting portion. In Fig. 1B, the frame-shaped abutting portion of the package base 1 is coated with a thermosetting silicon resin 10, and this silicon resin 10 is hardened by heating the package base 1 in a furnace (not shown) at a constant temperature, for example, approximately 150°C, so that the silicon resin 10 is completely hardened and becomes a silicon rubber. Before hardening the thermosetting silicon resin 10 is in liquid state and advantageously has a thixotropic property, so that a cross-sectional shape thereof after coating on the package base 1 remains even during and after the hardening thereof.

Such a silicon resin 10 includes, for example, a filler of alumina, approximately 80%, and has a thixotropic property of 3.0 (viscosity at 6 rpm/viscosity at 30 rpm: revolutional speed of a viscometer).

As shown in Fig. 1C, the silicon rubber 10 is then coated with a thermosetting sealing resin 11 having a good adhesion with the silicon rubber, after the silicon resin (rubber) 10 has been completely hardened. The thermosetting sealing resin 11 may be an adhesive silicon resin or an adhesive epoxy resin having a good sealing property.

As shown in Fig. 1D, the package cap 7 made of, for example, a metal plate, is provided with through holes at positions corresponding to the holes 12 of the package base 1. Also, the cap 7 is provided with a corresponding frame-shaped abutting portion. Accordingly, the package cap 7 is placed on the package base 1 and positioned thereon, and the package base 1 and the cap 7 are then fastened to each other by bolts 13 inserted into the holes 12, and nuts 14, whereby the package base 1 and the cap 7 are pressed together with an appropriate screw torque, for example, 0.1 to 0.49 Nm (1 to 5 kg.cm). According to this fastening method, the pressure can be adjusted more easily and desirably than the fastening method of the prior art using a pressure clip as mentioned above, and thus the silicon rubber 10 can be properly positioned and adhered to the sealing resin 11.

Then, the semiconductor package comprising the package base 1 and the cap 7 is placed in a furnace (not shown) to heat the package at a constant temperature, for example, approximately 150°C, for a predetermined time such as 1 to 4 hours, to thermoset the sealing resin 11. After the predetermined time has lapsed, the cap 7 is firmly adhered to the package base 1, and the semiconductor package is then removed from the furnace. The bolts 13 and the nuts 14 are left on the package, to maintain the fastening together of the package base 1 and the cap 7.

In the present invention, even though the pressure in the cavity 1a of the package base 1 is made higher than the ambient pressure by an expansion of the air confined in the cavity 1a during the above-mentioned heat-hardening step, the silicon resin has been completely hardened in the previous step and is now a resilient silicon rubber 10, which functions as a packing seal during the heat-hardening step. Therefore, even if a pressure difference is generated between that of the cavity 1a and that outside the package, the sealing resin 11, which has not been completely hardened, is prevented from moving toward the outside from the cavity 1a of the package base 1. Accordingly, a required sealing resin contact area between the package base 1 and the cap 7 can be obtained and the generation of pin holes in the sealing resin can be prevented.

According to an experimental result, it was confirmed that a generation of pin holes was significantly reduced in the embodiment of this invention as follows.

| | Rate of generation of pin holes |
|---|---|
| Prior art (using a pressure clip) | 8/10 (80%) |
| Embodiment of this invention | 0/10 (0%) |

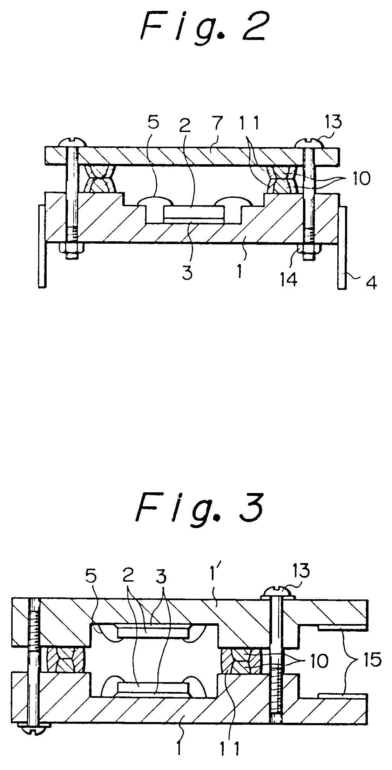

Figure 2 illustrates a second embodiment of a sealing process of this invention. Here, the same or similar members as those of the first embodiment are indicated by the same reference numerals.

In this embodiment, not only the package base 1 but also the cap 7 are provided with corresponding frame-shaped abutting portions, which are both coated with the thermosetting silicon resin 10, respectively. After the silicon resin 10 is hardened to become a silicon rubber, the silicon rubber 10 of the package base 1 and of the cap 7 is coated with a thermosetting sealing resin, respectively. In this embodiment, the same advantages as obtained by the previous embodiment can be thus obtained. Also, in this case, only one of the silicon rubber 10 of the package base 1 and of the cap 7 may be coated with a thermosetting sealing resin.

Figure 3 illustrates a third embodiment of a sealing process of this invention. Here, the same or similar members as those of the first and second embodiments are indicated by the same or corresponding reference numerals.

In this embodiment, to manufacture a module type semiconductor device, a second or upper package base 1' is used in place of the cap 7. This upper package base 1' has a same shape and size as the first or lower package base 1, and another semiconductor chip 2 is mounted in a cavity of the upper package base 1'. Accordingly, the lower and upper package bases 1 and 1' have corresponding frame-shaped abutting portions, respectively, which are coated with a thermosetting silicon resin 10, respectively. After the silicon resin of both portions is completely hardened to become a silicon rubber, it is coated with a thermosetting sealing resin 11, respectively. Then, the lower and upper package bases 1 and 1' are abutted against and fastened to each other by bolts 13, and the sealing resin 11 is hardened in the same manner as in the previous embodiments.

In this embodiment, reference numerals 15 refers to outer electrical terminals provided on the lower and upper package bases 1 and 1', a socket (not shown) being inserted between these terminals 15 for electrically connecting same to a cable connector or the like. Also, in this embodiment, the frame-shaped abutting portion of only one of the lower and upper package bases 1 and 1' may be coated with a thermosetting silicon resin 10. Alternatively, only one of the silicon rubber portions 10 may be coated with the sealing resin 11.

As an example, this invention can be used for hermetically sealing a semiconductor device including a wafer-scale LSI (large scale integrated circuit) in place of an IC chip or an ordinally sized LSI. Such a wafer-scale LSI has a diameter similar to that of the semiconductor wafer, for example, a diameter of 152.4 mm (6 inch).

## Claims

1.  A process of hermetically sealing a semiconductor device comprising a package base (1), on which a semiconductor chip (2) is mounted, and a package cap (7), said base and said cap having corresponding frame-shaped abutting portions for sealing said cap to said base by a resin adhesive provided between said abutting portions, wherein said process comprises the following steps of:

    coating said frame-shaped abutting portion of at least one of said base (1) and said cap (7) with a thermosetting silicon resin (10);

    hardening said silicon resin by heating said one of base and cap until said silicon resin is completely hardened and has become a silicon rubber;

    coating said silicon rubber with a thermosetting sealing resin (11) having a good adhesion with said silicon rubber;

    abutting said cap against said base; and

    heating said base and said cap while a pressure is exerted thereon to press said base and said cap toward each other.

2. A process as claimed in claim 1, wherein said silicon resin (10) is hardened at a temperature of 150°C.

3. A process as claimed in claim 1, wherein said thermosetting sealing resin (11) is an epoxy resin.

4. A process as claimed in claim 1, wherein said thermosetting sealing resin (11) is a silicon resin.

5. A process as claimed in claim 1, wherein said pressure is exerted on said base (1) and said cap (7) by screw means (12, 13, 14) with a screw torque of 0.1-0.49 Nm (1-5 kg.cm).

6. A process as claimed in claim 1, wherein said semiconductor chip is a wafer scale LSI.

7. A process as claimed in any one of claims 1-6, wherein both of said frame-shaped abutting portions of said base (1) and said cap (7) are coated with a thermosetting silicon resin (10), respectively, and at least one of said hardened silicon resin rubber portions is coated with a thermosetting sealing resin (11).

8. A process as claimed in claim 7, wherein both of said silicon rubber portions are coated with a thermosetting sealing resin (11), respectively.

9. A process as claimed in any one of claims 1-6, wherein said cap is a second package base (1') on which a second semiconductor chip (2) is mounted.

10. A process as claimed in claim 9, wherein both of said frame-shaped abutting portions of said first and second bases (1, 1') are coated with a thermosetting silicon resin (10), respectively, and at least one of said hardened silicon resin rubber portions is coated with a thermosetting sealing resin (11).

11. A process as claimed in claim 10, wherein both of said silicon rubber portions (10) are coated with a thermosetting sealing resin (11), respectively.


**Patentansprüche**

1. Verfahren zum hermetischen Versiegeln einer Halbleitervorrichtung, die eine Gehäusebasis (1), auf der ein Halbleiterchip (2) befestigt ist, und eine Gehäuseabdeckung (7) umfaßt, wobei die Basis und die Abdeckung entsprechende rahmenförmige Stoßabschnitte zum Versiegeln der Abdeckung mit der Basis durch einen zwischen den Stoßabschnitten vorgesehenen Harzkleber aufweisen, wobei das Verfahren die folgenden Schritte umfaßt:
Beschichten des rahmenförmigen Stoßabschnittes wenigstens der Basis (1) oder der Abdeckung (7) mit einem warmaushärtenden Silikonharz (10);
Härten des Silikonharzes durch Erwärmen der Basis oder der Abdeckung, bis das Silikonharz vollständig gehärtet ist und zu Silkongummi geworden ist;
Beschichten des Silikongummis mit einem warmaushärtenden Versiegelungsharz (11), das eine gute Anhaftfähigkeit an dem Silikongummi hat;
Anlegen der Abdeckung an der Basis; und
Erwärmen der Basis und der Abdeckung, während auf diese Druck ausgeübt wird, um die Basis und die Abdeckung gegeneinanderzupressen.

2. Verfahren nach Anspruch 1, bei dem das Silikonharz (10) bei einer Temperatur von 150°C gehärtet wird.

3. Verfahren nach Anspruch 1, bei dem das warmaushärtende Versiegelungsharz (11) ein Epoxydharz ist.

4. Verfahren nach Anspruch 1, bei dem das warmaushärtende Versiegelungsharz (11) ein Silikonharz ist.

5. Verfahren nach Anspruch 1, bei dem der Druck auf die Basis (1) und die Abdeckung (7) durch Schraubeneinrichtungen (12, 13, 14) mit einem Schraubendrehmoment von 0,1 bis 0,49 Nm (1-5 kg.cm) ausgeübt wird.

6. Verfahren nach Anspruch 1, bei dem der Halbleiterchip ein LSI in Wafergröße ist.

7. Verfahren nach einem der Ansprüche 1-6, bei dem die rahmenförmige Stoßabschnitte sowohl der Basis (1) als auch der Abdeckung (7) jeweils mit einem warmaushärtenden Silikonharz (10) beschichtet werden und wenigstens einer der gehärteten Silikonharzgummiabschnitte mit einem warmaushärtenden Versiegelungsharz (11) beschichtet wird.

**8.** Verfahren nach Anspruch 7, bei dem beide Silikongummiabschnitte jeweils mit einem warmhärtenden Versiegelungsharz (11) beschichtet werden.

**9.** Verfahren nach einem der Ansprüche 1-6, bei dem die Abdeckung eine zweite Gehäusebasis (1′) ist, auf der ein zweiter Halbleiterchip (2) befestigt ist.

**10.** Verfahren nach Anspruch 9, bei dem die beiden rahmenförmigen Stoßabschnitte der ersten und der zweiten Basis (1, 1′) jeweils mit einem warmaushärtenden Silikonharz (10) beschichtet werden und wenigstens einer der gehärteten Silikonharzgummiabschnitte mit einem warmaushärtenden Versiegelungsharz (11) beschichtet wird.

**11.** Verfahren nach Anspruch 10, bei dem beide Silikongummiabschnitte (10) jeweils mit einem warmaushärtenden Versiegelungsharz (11) beschichtet werden.

## Revendications

**1.** Procédé de scellement hermétique d'un dispositif à semiconducteur comprenant une base de boîtier (1), sur laquelle est montée une puce semiconductrice (2), et un couvercle de boîtier (7), ladite base et ledit couvercle ayant des parties d'appui en forme de cadre correspondantes destinées à sceller ledit couvercle à ladite base à l'aide d'un adhésif du type résine placé entre lesdites parties d'appui, où ledit procédé comprend les opérations suivantes:

revêtir ladite partie d'appui en forme de cadre d'au moins un des éléments que constituent ladite base (1) et ledit couvercle (7) à l'aide d'une résine de silicone thermodurcissable (10);

faire durcir ladite résine de silicone en chauffant ledit élément constitué par la base ou le couvercle jusqu'à ce que ladite résine de silicone soit complètement durcie et soit devenue du caoutchouc de silicone;

revêtir ledit caoutchouc de silicone à l'aide d'une résine de scellement thermodurcissable (11) qui présente une bonne adhérence vis-à-vis dudit caoutchouc de silicone;

mettre en appui ledit couvercle contre ladite base ; et

chauffer ladite base et ledit couvercle tout en exerçant une pression sur ceux-ci afin de presser ladite base et ledit couvercle en direction l'un de l'autre.

**2.** Procédé selon la revendication 1, où on fait durcir ladite résine de silicone (10) à une température de 150°C.

**3.** Procédé selon la revendication 1, où ladite résine de scellement thermodurcissable (11) est une résine époxy.

**4.** Procédé selon la revendication 1, où ladite résine de scellement thermodurcissable (11) est une résine de silicone.

**5.** Procédé selon la revendication 1, où on exerce sur ladite base (1) et ledit couvercle (7) ladite pression à l'aide de moyens de vissage (12, 13, 14) avec un couple de vissage de 0,1 à 0,49 N.m (de 1 à 5 kg.cm).

**6.** Procédé selon la revendication 1, où ladite puce semiconductrice est un circuit intégré à grande échelle pour intégration sur plaquette.

**7.** Procédé selon l'une quelconque des revendications 1 à 6, où on revêt lesdites parties d'appui en forme de cadre de ladite base (1) et dudit couvercle (7) toutes deux respectivement à l'aide d'une résine de silicone thermodurcissable (10), et on revêt d'une résine de scellement thermodurcissable (11) au moins l'une desdites parties de caoutchouc de résine de silicone durcie.

**8.** Procédé selon la revendication 7, où on revêt lesdites parties de caoutchouc de silicone toutes deux respectivement d'une résine de scellement thermodurcissable (11).

**9.** Procédé selon l'une quelconque des revendications 1 à 6, où ledit couvercle est une deuxième base de boîtier (1') sur laquelle une deuxième puce semiconductrice (2) est montée.

10. Procédé selon la revendication 9, où on revêt lesdites parties d'appui en forme de cadre desdites première et deuxième bases (1, 1') toutes deux respectivement à l'aide d'une résine de silicone thermodurcissable (10) et on revêt au moins l'une desdites parties de caoutchouc de résine de silicone durcie à l'aide d'une résine de scellement thermodurcissable (11).

11. Procédé selon la revendication 10, où on revêt lesdites parties de silicone (10) toutes deux respectivement à l'aide d'une résine de scellement thermodurcissable (11).

# Fig. 1A

# Fig. 1B

# Fig. 1C

# Fig. 1D

# Fig. 2

# Fig. 3